# DEMANDE DE BREVET EUROPEEN

(11) **EP 1 063 771 A1**
(43) Date de publication de la demande: **27.12.2000**
(21) Numéro de dépôt: 00401739.8
(22) Date de dépôt: 19.06.2000
(51) Int. Cl.: H03K 17/0412

(54) **Cummutateur ultra-rapide à haute fréquence de récurrence**

(30) Priorité: 22.06.1999 FR 9907947
(71) Demandeur: COMMISSARIAT A L'ENERGIE ATOMIQUE, 75752 Paris Cédex 15 (FR); COMPAGNIE GENERALE DES MATIERES NUCLEAIRES, 78140 Velizy Villacoublay (FR)
(72) Inventeur: Chatroux, Daniel, 26200 Montelimar (FR); Regnard, Philippe, 84500 Bollene (FR); Villard, Jean-François, 84100 Uchaux (FR)
(74) Mandataire: Poulin, Gérard

(57) **Abrégé**

L'invention concerne un commutateur ultra-rapide comportant :
- au moins un transistor MOSFET (2) ayant une grille (g), un drain (d) et une source (s) ;
- des moyens de commande (3) pour appliquer sur la grille du transistor, successivement, une tension de grille négative (- Vg), puis une tension de grille positive (+ Vg) ;
- au moins un transformateur abaisseur de tension (4) ayant un enroulement primaire (4a) connecté aux moyens de commande et un enroulement secondaire (4b) connecté entre la grille et la source du transistor et dont le rapport de transformation est inférieur ou égal à 1.

## Description

### Domaine de l'invention

L'invention concerne un commutateur ultra-rapide à haute fréquence de récurrence. Il s'agit, en particulier, d'un commutateur de puissance pour générateur d'impulsions ultra-rapides (c'est-à-dire ayant un temps de commutation inférieur à 2 nanosecondes), à fréquence de récurrence élevée (jusqu'à plusieurs dizaines de kilohertz) et fonctionnant sous haute-tension (c'est-à-dire au moins 100 volts).

L'invention concerne aussi des interrupteurs haute tension et fort courant réalisés en associant plusieurs commutateurs ultra-rapides.

De tels commutateurs trouvent des applications dans le domaine des alimentations pulsées, en électronique de puissance. Ils peuvent être utilisés, plus particulièrement, dans les générateurs d'alimentation de cristaux électro-optiques et de cellules de Pockels.

### Etat de la technique

Pour réaliser des commutateurs rapides se mettant en conduction en moins de 2 nanosecondes, il est classique d'utiliser un phénomène d'avalanche dans un semi-conducteur tel qu'une diode ou un transistor bipolaire.

Cette technique consiste à appliquer une tension élevée entre les bornes principales d'un transistor ou d'une diode, jusqu'à effondrement de la tension entre ces bornes par mise en conduction par le régime d'avalanche. Cette technique est décrite, par exemple, dans l'article de R. J. BAKER, intitulé « High voltage pulse generation using current mode second breakdown in a bipolar junction transistor », paru dans Rev. Sci. Instrum. 62(4), April 1991, 1 031 - 1 036, ou bien dans l'article du même auteur, intitulé « Nanosecond switching using power MOSFETs », paru dans Rev. Sci. Instrum. 61(8), August 1990, 2 211 - 2 213 ; ces deux documents concernent l'utilisation de transistors bipolaires. L'utilisation de diodes est décrite dans l'article de D. M. BENZEL et al., intitulé « 1 000 V, 300 ps pulse-generation circuit using silicon avalanche devices », paru dans Rev. Sci. Instrum. 56(7), July 1985, 1 456 - 1 458.

Une autre technique classique consiste à utiliser des transistors MOSFETs dont les grilles sont commandées par des signaux de forte amplitude en tension. Cette technique est décrite, par exemple, dans l'article de R. J. BAKER, intitulé « Nanosecond switching using power MOSFETs », déjà cité ci-dessus, ainsi que dans l'article de R. J. BAKER et al., intitulé « A 500 V nanosecond pulse generator using cascade-connected power MOSFETs », paru dans Meas. Sci. Technol. 3 (1992), 775 - 777.

Cette technique consiste à commander des transistors MOSFETs par des tensions de grille d'amplitude importante (les articles ci-dessus donnent O V/40 V ou ± 20 V), ce qui provoque leur mise en conduction rapide (en 3 ns et 2 ns, respectivement, d'après les articles cités ci-dessus). Le circuit de commande de grille des transistors MOSFETs peut aussi utiliser un transistor bipolaire mis en conduction par avalanche à partir d'une tension de 200 V, comme décrit dans l'article de R. J. BAKER, intitulé « Nanosecond switching using power MOSFETs », déjà cité ci-dessus.

Les principaux problèmes posés par les dispositifs connus concernent la fiabilité des composants. En effet, le phénomène d'avalanche provoque une fatigue importante des transistors ou des diodes, ce qui diminue notablement leur durée de vie. D'autre part, la durée de vie des transistors MOSFETs diminue d'autant plus qu'on leur applique des signaux de grille d'amplitude élevée.

Les transistors MOSFETs sont les composants privilégiés pour la réalisation de commutateurs rapides, en raison de leur commande en tension par la grille et de la rapidité de leur mise en conduction. Cependant, lorsque l'on utilise un transistor MOSFET commandé par des tensions de grille compatibles avec une durée de vie élevée, les temps de commutation se trouvent limités en raison des inductances propres du boîtier, qui limitent le courant de grille lors de la décharge des capacités parasites du transistor (phénomène dit de « palier MILLER »).

En effet, lors de la mise en conduction du transistor MOSFET par application d'un signal de grille classique, la capacité grille/source du transistor est chargée en premier jusqu'à atteindre la tension de seuil sur la grille, ce qui amorce la conduction drain/source. Les capacités drain/source et grille/drain se déchargent ensuite rapidement. En particulier, le courant de décharge de la capacité grille/drain s'oppose au courant de grille. Le potentiel de grille reste alors constant (pallier MILLER), jusqu'à ce que la capacité grille/drain soit complètement déchargée, après quoi le potentiel de grille peut de nouveau augmenter normalement.

La rapidité de mise en conduction du transistor MOSFET est essentiellement liée à la valeur du courant drain/source pendant la phase de pallier MILLER, ce courant provenant essentiellement de la décharge des capacités parasites.

Ainsi, augmenter le courant de décharge des capacités parasites du transistor MOSFET en appliquant des signaux de grille d'amplitude élevée, permet d'accélérer la mise en conduction. L'application des signaux de grille peut se faire, par exemple, au moyen d'un transistor bipolaire mis en conduction par avalanche à partir d'une tension de 200 volts, comme cela est décrit dans l'article « Nanosecond switching using power MOSFET », déjà cité précédemment, ou au moyen d'un montage du type cascode, comme décrit dans l'article « A 500V nanosecond pulse generator using cascode connected power MOSFETs », de R. J. BAKER et B. P. JOHNSON, dans Meas. Sci. Technol. 3 (1992), 775 - 777.

Cependant, le montage de type cascode ne permet pas la mise en matrice des composants. Il n'est donc pas possible d'utiliser ce montage pour réaliser des commutations rapides de haute tension et de fort courant.

Une autre technique est basée sur le phénomène de recouvrement inverse des diodes. Ce phénomène correspond à la phase d'ouverture des diodes, pendant laquelle le composant laisse passer le courant inverse avant de le bloquer violemment, ce qui génère un front de tension très rapide, de l'ordre de la nanoseconde.

Les montages utilisés pour mettre en oeuvre ce phénomène peuvent comporter des diodes de redressement à avalanche contrôlée auxquelles sont appliquées des impulsions de courant, directe puis inverse, de même amplitude et de durée inférieure à la durée de vie des porteurs. C'est le cas du document intitulé « A novel nanosecond semiconductor opening switch for megavolt repetitive pulsed power technology : experiment and applications » de Y. A. KOTOV et al., 9^{th} Pulsed Power Conference (vol. 1), 1993, 134 - 139. Cependant, de tels montages présentent une dissipation d'énergie importante dans la diode, ce qui provoque des échauffements et interdit le fonctionnement à des fréquences de récurrence élevées.

Les montages utilisés pour mettre en oeuvre ce phénomène peuvent aussi comporter des cellules de commutation comprenant, notamment, un transistor MOSFET et une diode rapide, à laquelle on applique un courant direct, faible par rapport au courant inverse, comme cela est décrit dans la demande de brevet FR-A-2 765 049. Cependant, de tels montages présentent des problèmes de réglage des paramètres de la commutation. En effet, l'amplitude de la tension commutée n'est pas réglable et le retard sur l'instant d'apparition de la commutation est un facteur qui reste lié au temps de recouvrement inverse de la diode et qui, par conséquent, dépend de la température. Ceci nécessite la mise en oeuvre d'un asservissement du signal de synchronisation de la commutation.

### Exposé de l'invention

L'invention a justement pour but de remédier aux inconvénients des techniques décrites précédemment. A cette fin, elle propose un commutateur de puissance ultra-rapide, utilisable dans un générateur d'impulsions ultra-rapides fonctionnant à une fréquence de récurrence élevée et sous une haute tension.

De façon plus précise, l'invention concerne un commutateur ultra-rapide comportant :
- au moins un transistor MOSFET ayant une grille, un drain et une source ;
- une source haute tension connectée entre le drain et la source du transistor MOSFET ;
- des moyens de commande pour appliquer sur la grille du transistor, successivement, une tension de grille négative (- Vg), puis une tension de grille positive (+ Vg) ;
- au moins un transformateur abaisseur de tension ayant un enroulement primaire connecté aux moyens de commande et un enroulement secondaire connecté entre la grille et la source du transistor et dont le rapport de transformation est inférieur ou égal à 1.

Avantageusement, l'enroulement secondaire du transformateur comporte une seule spire.

Selon l'invention, le transistor peut être un transistor de puissance aux bornes duquel est appliquée une haute tension chutant en moins de 2 nanosecondes.

De préférence, la valeur de la tension de grille du transistor est inférieure ou égale, en valeur absolue, à la valeur de la tension spécifiée par le constructeur.

Selon un mode de réalisation de l'invention, le commutateur comporte N transistors MOSFETs connectés en parallèle (avec N ≥ 2) et N transformateurs connectés en parallèle par leurs enroulements primaires.

Selon un autre mode de réalisation de l'invention, le commutateur comporte N transistors MOSFETs connectés en série (avec N ≥ 2) et N transformateurs connectés en série.

Selon un mode de réalisation des moyens de commande de l'invention, ceux-ci consistent en un circuit push-pull incluant une inductance interne inférieure à 50 nH.

L'invention concerne aussi un interrupteur haute tension et fort courant comportant une pluralité de commutateurs ultra-rapides connectés en parallèle, en série ou sous forme de matrice.

### Brève description des figures

- la figure 1 représente schématiquement un commutateur ultra-rapide conforme à l'invention ;
- la figure 2 représente un mode de réalisation des moyens de commande de la tension de grille du commutateur de l'invention ; et
- la figure 3 représente les diagrammes temporels de la tension de grille et de la tension drain/source du commutateur de l'invention.

### Description détaillée de modes de réalisation de l'invention

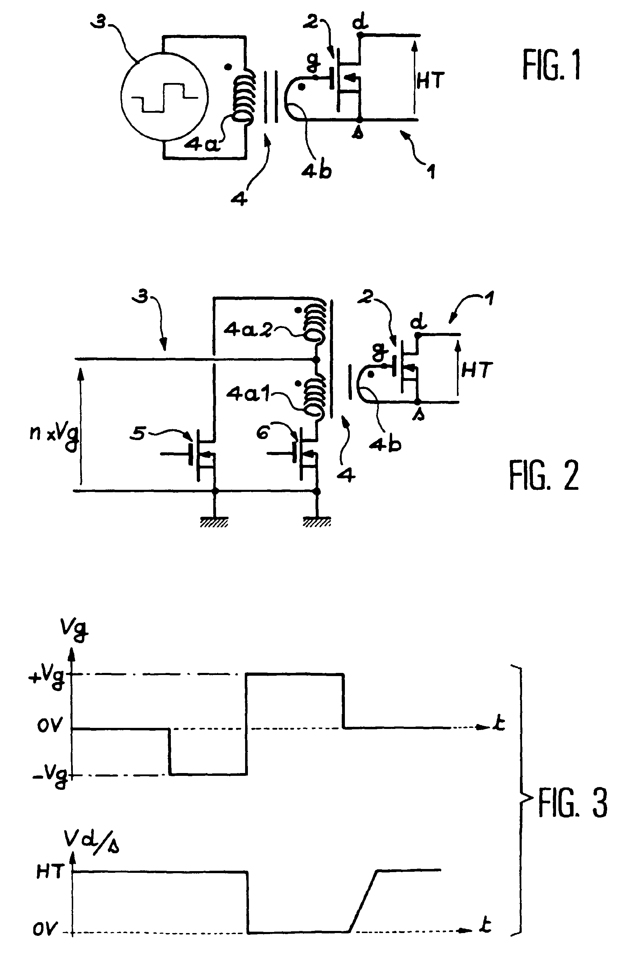

L'invention concerne un commutateur ultra-rapide à haute fréquence de récurrence, illustré sur la figure 1.

Ce commutateur 1 comporte au moins un transistor MOSFET 2 de puissance, ayant une grille g, un drain d et une source s. Entre les bornes d et s du transistor 2, la haute tension HT (supérieure ou égale à 100 V) chute en moins de 2 nanosecondes.

Le commutateur 1 comporte, de plus, des moyens de commande 3 dont le rôle est d'appliquer, sur la grille g du transistor 2, une tension de grille Vg. Cette tension de grille Vg est la tension de grille recommandée par le constructeur du transistor, ce qui signifie que la valeur de la tension Vg est inférieure ou égale à la valeur de tension spécifiée par le constructeur. Cette tension Vg peut être positive ; elle est alors notée + Vg. Elle peut aussi être négative ; dans ce cas, elle est notée - Vg (on notera que + Vg et - Vg ont la même valeur, en valeur absolue).

Le circuit de commande 3 du transistor MOSFET 2 constitue, en fait, un circuit de type LC où L est l'inductance de câblage et C est la capacité grille/source du transistor 2. Le courant mis en jeu dans un circuit LC est d'autant plus grand que la capacité est initialement chargée en inverse.

Aussi, pour obtenir un commutateur rapide, l'invention propose d'accélérer la mise en conduction du transistor MOSFET 2, en augmentant le courant de décharge des capacités parasites du transistor. Pour cela, on charge la capacité grille/source du transistor 2 en appliquant, sur la grille g, une tension de grille négative (- Vg) ; on applique ensuite, sur la grille g, une tension de grille positive (+ Vg).

Comme représenté sur la figure 1, le commutateur de l'invention comporte au moins un transformateur 4 ayant un enroulement primaire 4a connecté aux bornes des moyens de commande 3 et un enroulement secondaire 4b connecté entre la grille g et la source s du transistor 2.

Le transformateur 4 est un abaisseur de tension dont le rapport de transformation est inférieur ou égal à 1.

Ce transformateur 4 peut consister, par exemple, en un tore de ferrite dont le primaire comporte cinq spires et dont le secondaire comporte une seule spire, d'où un rapport de transformation de 1/5^{ième}.

Pour obtenir des commutations rapides, il est important de limiter au mieux les inductances de câblage. Or, un rapport de transformation inférieur à un, permet au commutateur de fonctionner avec une tension plus élevée que Vg au niveau des moyens de commande 3. Ainsi, le fait de fonctionner avec une tension plus importante au niveau du primaire que du secondaire permet de réduire l'influence de ces inductances de câblage et, par conséquent, de simplifier le câblage lui-même.

De plus, dans le cas où l'enroulement secondaire 4b (appelé plus simplement « secondaire ») ne comporte qu'une seule spire, l'inductance des moyens de commande est aussi fortement réduite.

L'inductance totale des moyens de commande 3 peut ainsi être inférieure à 50 nanohenrys.

Le commutateur de l'invention, tel qu'il vient d'être décrit, peut être réalisé à l'aide de composants électroniques standards (comme le transistor MOSFET IRF 840 LC, par exemple), sur un circuit imprimé, ce qui permet une mise en oeuvre industrielle aisée et à faible coût.

Sur la figure 2, on a représenté schématiquement un mode de réalisation du circuit de commande du commutateur de l'invention.

Le circuit de commande 3 peut être, par exemple, un circuit push-pull comportant une source de tension continue générant une tension égale à n x Vg, avec n ≥ 1. Par exemple, dans le cas où le rapport de transformation est de 1/5^{ième}, la tension émise par la source de tension est de 5 x Vg.

Le circuit de commande 3 comporte alors, dans ce mode de réalisation, deux transistors MOSFETs 5 et 6, ainsi que deux enroulements 4a1 et 4a2 de cinq spires chacun, connectés en série et formant le primaire 4a du transformateur 4. Chacun des deux transistors 5 et 6 est connecté à l'une des bornes de l'ensemble d'enroulement primaire 4a.

Selon un mode de réalisation de l'invention, le commutateur 1 peut comporter plusieurs transistors MOSFETs 2 associés en parallèle ou en série et commandés par le même circuit de commande 3. Dans ce cas, il y a autant de transformateurs que de transistors ; et chaque transformateur 4 est connecté à la grille d'un transistor MOSFET ; il assure ainsi l'isolement galvanique entre le circuit de commande et le transistor.

Par exemple, la mise en parallèle des transistors et transformateurs peut se faire par les primaires des transformateurs 4. Ce mode de réalisation permet d'adapter le commutateur au courant de charge. La mise en série peut se faire par les tores en ferrites sur le primaire des transformateurs. Ce mode de réalisation permet d'adapter le commutateur à la tension commutée.

Sur la figure 3, on a représenté le diagramme temporel de la tension de grille Vg appliquée à la grille g du transistor 2 et la tension drain/source (Vd/s) de ce transistor, c'est-à-dire la haute tension HT obtenue en sortie du commutateur de l'invention.

Plus précisément, le premier chronogramme montre la tension Vg appliquée à la grille du transistor, à savoir une tension négative de valeur - Vg suivie d'une tension positive de valeur + Vg dont la durée correspond au temps de conduction choisi pour l'application.

Le second chronogramme montre l'évolution de la tension Vd/s obtenue en sortie du commutateur. Le front de mise en conduction a lieu au moment de l'application de la tension positive + Vg. La mise en conduction se fait en moins de 2 nanosecondes.

L'amplitude de la tension commutée est exactement égale à la valeur de la tension drain/source du transistor 2.

Le temps de retard sur l'apparition du front de commutation est constant.

Il est à noter que, plusieurs commutateurs ultra-rapides, tels que celui décrit précédemment, peuvent être associés, en parallèle, en série, ou sous forme de matrice, pour réaliser un interrupteur haute tension, fort courant.

## Revendications

1. Commutateur ultra-rapide, caractérisé en ce qu'il comporte :
- au moins un transistor MOSFET (2) ayant une grille (g), un drain (d) et une source (s) ;
- une source haute tension (HT) connectée entre le drain et la source du transistor MOSFET ;
- des moyens de commande (3) pour appliquer sur la grille du transistor, successivement, une tension de grille négative (- Vg), puis une tension de grille positive (+ Vg) ;
- au moins un transformateur abaisseur de tension (4) ayant un enroulement primaire (4a) connecté aux moyens de commande et un enroulement secondaire (4b) connecté entre la grille et la source du transistor et dont le rapport de transformation est inférieur ou égal à 1.

2. Commutateur ultra-rapide selon la revendication 1, caractérisé en ce que l'enroulement secondaire du transformateur comporte une seule spire.

3. Commutateur ultra-rapide selon l'une quelconque des revendications 1 et 2, caractérisé en ce que le transistor est un transistor de puissance aux bornes duquel est appliquée une haute tension chutant en moins de 2 nanosecondes.

4. Commutateur ultra-rapide selon l'une quelconque des revendications 1 à 3, caractérisé en ce que la valeur de la tension de grille (Vg) est inférieure ou égale, en valeur absolue, à la valeur de la tension spécifiée par le constructeur.

5. Commutateur ultra-rapide selon l'une quelconque des revendications 1 à 4, caractérisé en ce qu'il comporte N transistors MOSFETs connectés en parallèle (avec N ≥ 2) et N transformateurs connectés en parallèle par leurs enroulements primaires.

6. Commutateur ultra-rapide selon l'une quelconque des revendications 1 à 4, caractérisé en ce qu'il comporte N transistors MOSFETs connectés en série (avec N ≥ 2) et N transformateurs connectés en série.

7. Commutateur ultra-rapide selon l'une quelconque des revendications 1 à 6, caractérisé en ce que les moyens de commande comportent une inductance interne inférieure à 50 nH.

8. Interrupteur haute tension et fort courant, caractérisé en ce qu'il comporte une pluralité de commutateurs ultra-rapides selon l'une quelconque des revendications 1 à 7, connectés en parallèle, en série ou sous forme de matrice.
